# EUROPEAN PATENT APPLICATION

(11) **EP 4 518 012 A1**
(43) Date of publication of application: **05.03.2025**
(21) Application number: 23796327.7
(22) Date of filing: 24.04.2023
(51) Int. Cl.: H01M 50/571, H01M 50/105, H01M 50/178, H01M 50/211, H01M 50/50, H01M 50/553, H01M 50/557, H01M 50/569

(54) **BATTERY CELL AND BATTERY MODULE**

(30) Priority: 28.04.2022 JP 2022074724; 26.10.2022 JP 2022171314
(71) Applicant: AESC Japan Ltd., Kanagawa, 2520012 (JP)
(72) Inventor: OKAZUMI, Ryoma, Zama-shi, Kanagawa 252-0012 (JP); IZAWA, Takami, Zama-shi, Kanagawa 252-0012 (JP); SEKINO, Keizou, Zama-shi, Kanagawa 252-0012 (JP); FURUKAWA, Yuki, Zama-shi, Kanagawa 252-0012 (JP)
(74) Representative: Mathys & Squire
(86) International application number: PCT/JP2023/016131
(87) International publication number: WO 2023/210587

(57) **Abstract**

A battery cell (100) includes a battery element (110), an exterior member (120) sealing the battery element (110), a negative electrode terminal (134) electrically connected to the battery element (110) and drawn out of the exterior member (120), and a first insulation tape (140) covering the exterior member (120) around the negative electrode terminal. The first insulation tape (140) is at least partially bonded to each other.

## Description

### TECHNICAL FIELD

The present invention relates to a battery cell and a battery module.

### BACKGROUND ART

In recent years, various battery cells have been developed as a non-aqueous electrolyte secondary battery such as a lithium-ion secondary battery. A battery cell includes a battery element, an exterior member sealing the battery element, and a terminal electrically connected to the battery element and drawn out of the exterior member.

Patent Document 1 describes one example of a battery cell. In the battery cell, an end face of a side of an exterior member from which a terminal is drawn out is covered by an insulation tape.

Patent Document 2 describes one example of a battery cell. In the battery cell, an end face of a sealing portion of an exterior member is covered by a sealing tape.

In recent years, various battery modules including a plurality of battery cells have been developed. Each battery cell includes a battery element, an exterior member sealing the battery element, and a positive electrode tab and a negative electrode tab drawn out of the exterior member.

Patent Document 3 describes one example of a battery module. In the battery module, a positive electrode tab and a negative electrode tab are drawn out of opposite sides of the exterior member. In the battery module, a positive electrode tab of a single or a plurality of battery cells connected in parallel and a negative electrode tab of a single or a plurality of battery cells connected in parallel are bonded to each other. The positive electrode tab and the negative electrode tab are folded between a battery cell provided with the positive electrode tab and a battery cell provided with the negative electrode tab.

Patent Document 4 describes one example of a battery module. In the battery module, a plurality of tip end portions of a plurality of positive electrode tabs or a plurality of negative electrode tabs of a plurality of battery cells are bent toward an identical direction.

Patent Document 5 describes one example of a battery module. In the battery module, tip ends of a positive electrode tab and a negative electrode tab are bent.

### RELATED DOCUMENT

### PATENT DOCUMENT

Patent Document 1: Japanese Patent Application Publication No. H11-97064
Patent Document 2: Japanese Patent Application Publication No. 2007-265879
Patent Document 3: International Publication No. WO 2006/109610
Patent Document 4: International Publication No. WO 2016/020999
Patent Document 5: International Publication No. WO 2011/027817

### SUMMARY OF INVENTION

### TECHNICAL PROBLEM

### (Aspect 1)

Terminals of different battery cells may be electrically connected to each other. In this case, dissimilar metals of a metal on an end face of an exterior member of one battery cell and a metal on a surface of a terminal of another battery cell may contact with each other. When the dissimilar metals are in contact with each other, the potential difference between the dissimilar metals may make it difficult to prevent corrosion in at least one of the exterior member and the terminal. To prevent such corrosion, the end face of the exterior member may be covered with an insulation material such as an insulation tape as described in Patent Document 1 or 2, for example. Simply covering the end face of the exterior member with the insulation material, however, may not fix the insulation material to the exterior member around the terminal with sufficiently strong force.

One example of an object of an aspect 1 of the present invention is to fix an insulation material to an exterior member around a terminal with strong force. Another object of the aspect 1 of the present invention will become apparent from the description provided herein.

### (Aspect 2)

A positive electrode tab and a negative electrode tab may be folded between at least one battery cell and at least another one battery cell as described in Patent Document 3, for example. In this case, however, workability for connecting at least one battery cell and at least another one battery cell in series may be reduced.

One example of an object of an aspect 2 of the present invention is to improve workability for connecting at least one battery cell and at least another one battery cell in series. Another object of the aspect 2 of the present invention will become apparent from the description provided herein.

### SOLUTION TO PROBLEM

The aspect 1 of the present invention is as follows.
[1.1] A battery cell including:
   a battery element;
   an exterior member sealing the battery element;
   a terminal electrically connected to the battery element and drawn out of the exterior member; and
   an insulation material covering the exterior member around the terminal, wherein
   the insulation material is at least partially bonded to each other.
[1.2] The battery cell according to [1.1], wherein
   the insulation material includes at least two insulation materials bonded to each other.
[1.3] The battery cell according to [1.2], wherein
   at least one of the at least two insulation materials covers an end portion of at least another one of the at least two insulation materials.
[1.4] The battery cell according to [1.1], wherein
   a sheet of the insulation material is folded and portions of the sheet of the insulation material are bonded to each other.
[1.5] The battery cell according to [1.1], wherein
   the insulation material defines a slit through which the terminal is drawn out.
[1.6] A battery module including:
   the battery cell according to any one of [1.1] to [1.5]; and
   another battery cell including another terminal being electrically connected to the terminal of the battery cell.

The aspect 2 of the present invention is as follows.
[2.1] A battery module including:
   at least one positive electrode tab including a predetermined first tip end portion bent about a predetermined first bent portion toward a predetermined direction; and
   at least one negative electrode tab bonded to the at least one positive electrode tab, the at least one negative electrode tab including a predetermined second tip end portion bent about a predetermined second bent portion toward the predetermined direction, wherein
   the first bent portion and the second bent portion are offset toward an opposite side of the predetermined direction relative to a virtual bisector of a virtual line segment connecting a predetermined first base end of the at least one positive electrode tab and a predetermined second base end of the at least one negative electrode tab.
[2.2] The battery module according to [2.1], further including
   a voltage detection portion bonded to at least one of the first tip end portion and the second tip end portion.
[2.3] A battery module including
   a plurality of tab groups including at least one positive electrode tab and at least one negative electrode tab bonded to each other, wherein
   each of tip end portions of the plurality of tab groups is bent toward an identical direction.
[2.4] The battery module according to [2.3], further including
   a plurality of voltage detection portions bonded to the tip end portions of the plurality of tab groups.
[2.5] A battery module including:
   at least one positive electrode tab including a predetermined first tip end portion bent toward a predetermined direction;
   at least one negative electrode tab bonded to the at least one positive electrode tab, the at least one negative electrode tab including a predetermined second tip end portion bent toward the predetermined direction; and
   a voltage detection portion bonded to at least one of the first tip end portion and the second tip end portion.

### ADVANTAGEOUS EFFECTS OF INVENTION

According to the aspect 1 of the present invention, an insulation material can be fixed to the exterior member around the terminal with strong force.

According to the aspect 2 of the present invention, workability for connecting at least one battery cell and at least another one battery cell in series can be improved.

### BRIEF DESCRIPTION OF THE DRAWINGS

[Fig. 1] A perspective view of a battery module according to an embodiment 1.
[Fig. 2] A top view of a front portion of the battery module according to the embodiment 1.
[Fig. 3] An A-A sectional schematic view of Fig. 2.
[Fig. 4] A side view of a front portion of a battery cell according to the embodiment 1.
[Fig. 5] A B-B sectional schematic view of Fig. 4.
[Fig. 6] A sectional schematic view for describing a first insulation tape of a battery cell according to a variant 1.1.
[Fig. 7] A sectional schematic view for describing a first insulation tape of a battery cell according to a variant 1.2.
[Fig. 8] A sectional schematic view for describing a first insulation tape of a battery cell according to a variant 1.3.
[Fig. 9] A sectional schematic view for describing a first insulation tape of a battery cell according to a variant 1.4.
[Fig. 10] A perspective view of a front portion of a battery module according to an embodiment 2.
[Fig. 11] An A-A' sectional view of Fig. 10.
[Fig. 12] A top view of a front portion of a first battery cell and a second battery cell of a plurality of battery cells according to the embodiment 2.
[Fig. 13] A view for describing a first example of a method of manufacturing the battery module according to the embodiment 2.
[Fig. 14] A view for describing the first example of the method of manufacturing the battery module according to the embodiment 2.
[Fig. 15] A view for describing the first example of the method of manufacturing the battery module according to the embodiment 2.
[Fig. 16] A view for describing a method of manufacturing a battery module according to a comparative embodiment.
[Fig. 17] A view for describing the method of manufacturing the battery module according to the comparative embodiment.
[Fig. 18] A view for describing a second example of the method of manufacturing the battery module according to the embodiment 2.
[Fig. 19] A view for describing the second example of the method of manufacturing the battery module according to the embodiment 2.
[Fig. 20] A top view of a front portion of a battery module according to a variant 2.1.
[Fig. 21] A top view of a front portion of a battery module according to a variant 2.2.

### DESCRIPTION OF EMBODIMENTS

### (Embodiment 1)

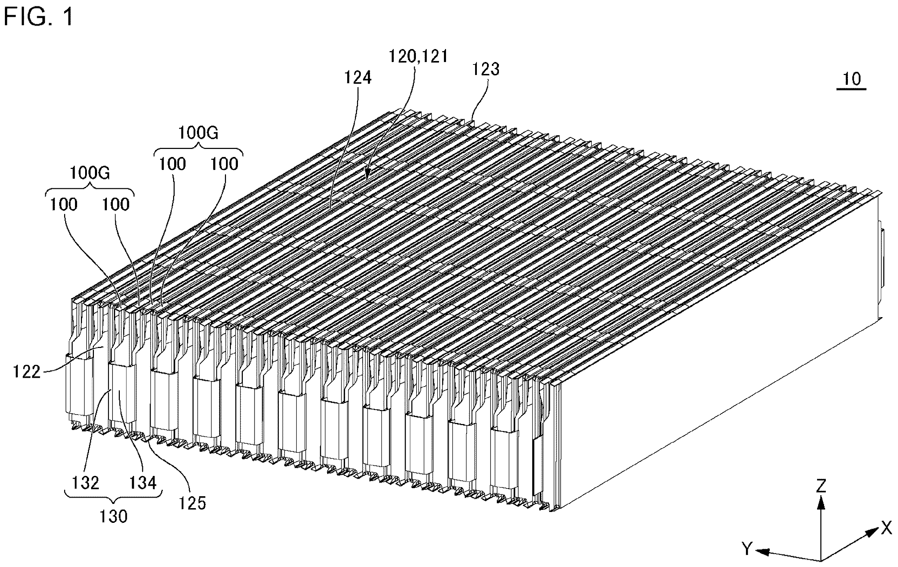

Hereinafter, an embodiment 1 and variants of the present invention will be described by using the drawings. A similar component is assigned with a similar reference sign throughout all the drawings in Figs. 1 to 9 relating to the embodiment 1, and description therefor will be omitted as appropriate.

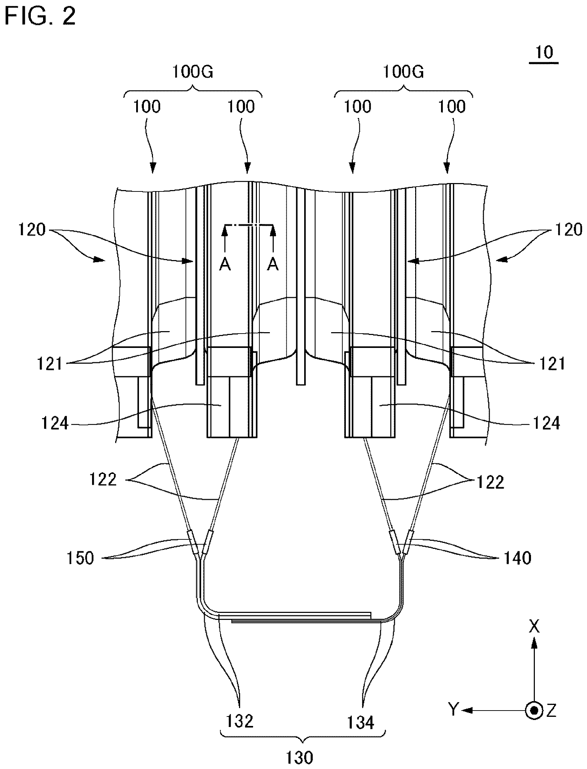

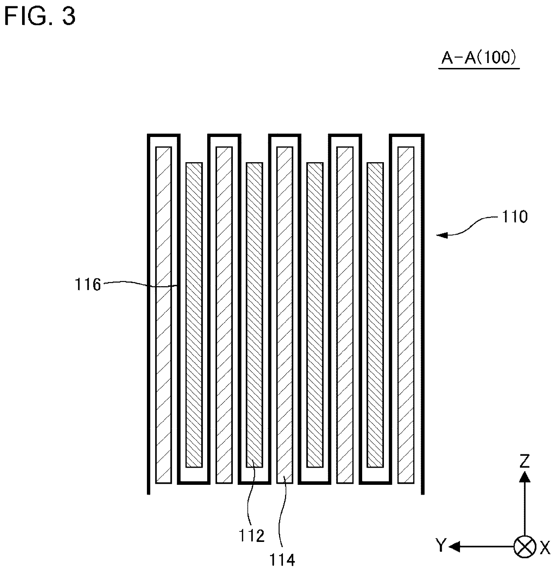

Fig. 1 is a perspective view of a battery module 10 according to the embodiment 1. Fig. 2 is a top view of a front portion of the battery module 10 according to the embodiment 1. Fig. 3 is an A-A sectional schematic view of Fig. 2.

For illustrative purposes, arrows indicating X direction, Y direction, and Z directions are assigned in each figure. The X direction is a direction parallel to a front-rear direction of the battery module 10. The Y direction is a direction perpendicular to the X direction. The Y direction is a direction parallel to a left-right direction of the battery module 10. The Z direction is a direction perpendicular to both of the X direction and Y direction. The Z direction is a direction parallel to an up-down direction of the battery module 10. A direction pointed by the arrow indicating the X direction, a direction pointed by the arrow indicating the Y direction, and a direction pointed by the arrow indicating the Z direction are a rear direction, a left direction, and an up direction, respectively. The relationship between the X direction, Y direction, and Z directions and the front-rear, left-right, and up-down directions of the battery module 10, however, is not limited to this example. A circle with a dot indicating the X direction, Y direction, or Z direction indicates that the arrow indicating the direction extends from the back toward the front of the plane of the paper. A circle with a cross indicating the X direction, Y direction, or Z direction indicates that the arrow indicating the direction extends from the front toward the back of the plane of the paper.

As illustrated in Fig. 1, the battery module 10 includes a plurality of battery cells 100. Each of the battery cells 100 has a long direction substantially parallel to the X direction. Each of the battery cells 100 has a short direction substantially parallel to the Z direction. Each of the battery cells 100 has a thickness direction substantially parallel to the Y direction. The plurality of battery cells 100 are stacked in the Y direction. The shape of each of the battery cells 100 is not limited to this example.

Each of the battery cells 100 includes a battery element 110, an exterior member 120, a positive electrode terminal 132, and a negative electrode terminal 134. The "terminal" such as the positive or negative electrode terminal may be referred to as a "tab" as needed.

As illustrated in Fig. 3, the battery element 110 includes a plurality of positive electrodes 112, a plurality of negative electrodes 114, and a separator 116. The plurality of positive electrodes 112 and the plurality of negative electrodes 114 are alternatingly stacked in the Y direction. In the example illustrated in Fig. 3, the separator 116 has a substantially zigzag shape as viewed from the X direction. Specifically, the separator 116 is folded alternatingly on the bottom end side of the positive electrodes 112 and on the top end side of the negative electrodes 114 as viewed from the X direction. The shape of the separator 116, however, is not limited to this example. For example, the separator 116 may be folded alternatingly on the top end side of the positive electrodes 112 and on the bottom end side of the negative electrodes 114 as viewed from the X direction. Alternatively, a plurality of substantially sheet-shaped separators 116 may be arranged between the positive electrode 112 and the negative electrode 114 adjacent in the Y direction.

As illustrated in Figs. 1 and 2, the exterior member 120 includes an accommodation portion 121, a front sealing portion 122, a rear sealing portion 123, an upper sealing portion 124, and a lower sealing portion 125.

The accommodation portion 121 accommodates the battery element 110 and a not-illustrated electrolyte. A front portion, a rear portion, an upper portion, and a lower portion of the accommodation portion 121 are sealed by the front sealing portion 122, the rear sealing portion 123, the upper sealing portion 124, and the lower sealing portion 125, respectively. Thus, an accommodation space for the battery element 110 of the accommodation portion 121 is sealed from an external space. Accordingly, the exterior member 120 seals the battery element 110.

In the embodiment 1, the exterior member 120 is composed of two sheets of laminate films covering opposite sides in the Y direction of the battery element 110. Each of the laminate films includes a metal layer such as an aluminum layer. The two sheets of laminate films are bonded to each other at the front sealing portion 122, the rear sealing portion 123, the upper sealing portion 124, and the lower sealing portion 125 by a bonding method such as thermal fusion bonding. The structure of the exterior member 120, however, is not limited to this example. For example, one sheet of laminate film may be folded at one of an upper portion and lower portion of the battery element 110. In this example, a sealing portion is formed at the other of the upper portion and lower portion of the battery cell 100. In this example, the front sealing portion 122 and the rear sealing portion 123 are formed at the front portion and the rear portion of the battery cell 100 respectively similarly to the embodiment 1.

In the embodiment 1, the front sealing portion 122 is drawn frontward out of the accommodation portion 121. The rear sealing portion 123 is drawn backward out of the accommodation portion 121. The upper sealing portion 124 is drawn upward out of the accommodation portion 121 and is folded along an upper face of the battery element 110. The lower sealing portion 125 is drawn downward out of the accommodation portion 121 and is folded along a lower face of the battery element 110. The shape of each sealing portion, however, is not limited to this example.

In each of the battery cells 100, a tip end portion of one of the positive electrode terminal 132 and the negative electrode terminal 134 is drawn frontward out of the front sealing portion 122. A base end portion of the terminal drawn out of the front sealing portion 122 is sealed by the front sealing portion 122. In each of the battery cells 100, a tip end portion of the other of the positive electrode terminal 132 and the negative electrode terminal 134 is drawn backward out of the rear sealing portion 123. A base end portion of the terminal drawn out of the rear sealing portion 123 is sealed by the rear sealing portion 123. In each of the battery cells 100, the positive electrode terminal 132 and the negative electrode terminal 134 are electrically connected to the plurality of positive electrodes 112 and the plurality of negative electrodes 114 respectively. Thus, the positive electrode terminal 132 and the negative electrode terminal 134 are electrically connected to the battery element 110.

In the embodiment 1, a plurality of cell groups 100G are connected in series from a cell group 100G located at one end in the Y direction to a cell group 100G located at another end in the Y direction. Each of the cell groups 100G includes a plurality of battery cells 100 connected in parallel. In the embodiment 1, each of the cell groups 100G includes two battery cells 100 adjacent in the Y direction. The two positive electrode terminals 132 drawn out of the two battery cells 100 included in each of the cell groups 100G are directed to the same side in the X direction. The two negative electrode terminals 134 drawn out of the two battery cells 100 included in each of the cell groups 100G are directed to the same side in the X direction. The positive electrode terminal 132 and the negative electrode terminal 134 drawn out of one of the cell groups 100G adjacent in the Y direction and the positive electrode terminal 132 and the negative electrode terminal 134 drawn out of the other of the cell groups 100G adjacent in the Y direction are directed to opposite sides in the X direction. The two cell groups 100G adjacent in the Y direction include a terminal group 130 located in front of or behind the two cell groups 100G. The terminal group 130 includes the positive electrode terminal 132 and the negative electrode terminal 134 bonded to each other. In the battery module 10, accordingly, a plurality of terminal groups 130 located in front of the plurality of battery cells 100 and a plurality of terminal groups 130 located behind the plurality of battery cells 100 are arranged alternately.

In the example illustrated in Fig. 2, the two front sealing portions 122 of the right cell group 100G are tilted toward each other relative to the X direction from the back end toward the front end of each front sealing portion 122 as viewed from above. A first insulation tape 140 is provided on the tip end portion of each of the two front sealing portions 122. Thus, the tip end portions of the two front sealing portions 122 are close to or in contact with each other while the first insulation tapes 140 provided at the tip end portions are interposed. Similarly, the two front sealing portions 122 of the left cell group 100G are tilted toward each other relative to the X direction from the back end toward the front end of each front sealing portion 122 as viewed from above. A second insulation tape 150 is provided on the tip end portion of each of the two front sealing portions 122. Thus, the tip end portions of the two front sealing portions 122 are close to or in contact with each other while the second insulation tapes 150 provided at the tip end portions are interposed.

The above description of the front sealing portion 122 using Fig. 2 is applicable to the rear sealing portion 123 as well.

In the example illustrated in Fig. 2, the tip end portions of the two negative electrode terminals 134 drawn out of the front ends of the two front sealing portions 122 of the right cell group 100G are bent into a substantially L-shape as viewed from above. Specifically, the tip end portion of the two negative electrode terminals 134 is bent at a substantially right angle from the front to the left as viewed from above. In the example illustrated in Fig. 2, the tip end portions of the two positive electrode terminals 132 drawn out of the front ends of the two front sealing portions 122 of the left cell group 100G are bent into a substantially L-shape as viewed from above. Specifically, the tip end portion of the two positive electrode terminals 132 is bent at a substantially right angle from the front to the right as viewed from above. The tip end portions of the two positive electrode terminals 132 and the tip end portions of the two negative electrode terminals 134 overlap each other in substantially parallel in the X direction. The tip end portions of the two positive electrode terminals 132 and the tip end portions of the two negative electrode terminals 134 are bonded to each other by a bonding method such as laser welding. Accordingly, the two positive electrode terminals 132 and the two negative electrode terminals 134 are electrically connected to each other.

The above description of the terminal group 130 using Fig. 2 is applicable to another terminal group 130 such as the terminal group 130 behind as well.

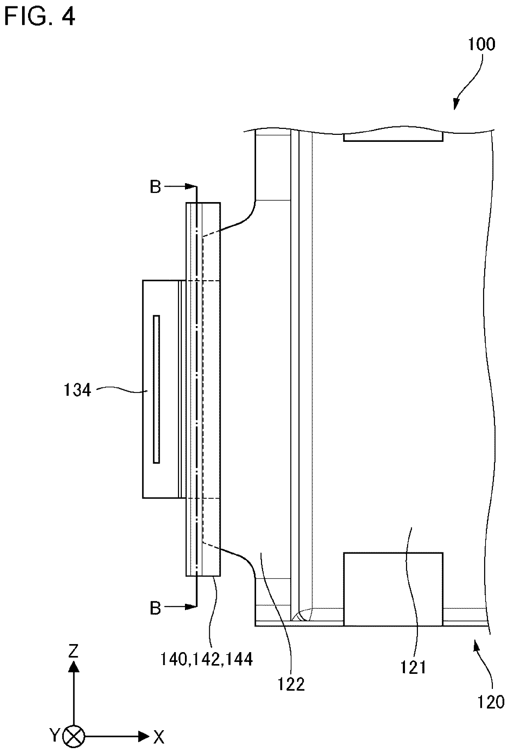

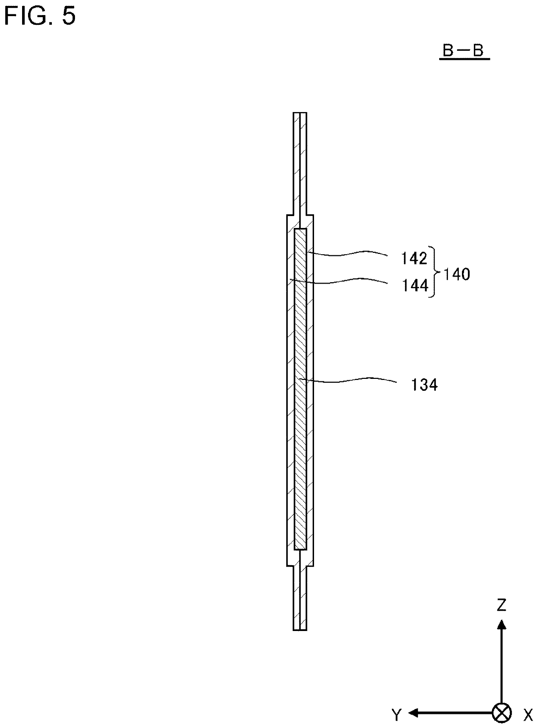

Fig. 4 is a side view of a front portion of the battery cell 100 according to the embodiment 1. Fig. 5 is a B-B sectional schematic view of Fig. 4.

The first insulation tape 140 will be described with reference to Figs. 4 and 5 and with reference to Fig. 2 as needed. The description of the first insulation tape 140 is applicable to the second insulation tape 150 as well.

The first insulation tape 140 includes a right insulation tape 142 and a left insulation tape 144.

The right insulation tape 142 and the left insulation tape 144 cover the front end portion of the front sealing portion 122 around the negative electrode terminal 134. As illustrated in Fig. 5, the right insulation tape 142 and the left insulation tape 144 are pasted onto the negative electrode terminal 134 from opposite sides in the Y direction of the negative electrode terminal 134 as viewed from the front. Specifically, the right insulation tape 142 is pasted onto a right side of the negative electrode terminal 134, and the left insulation tape 144 is pasted onto a left side of the negative electrode terminal 134 as viewed from the front.

The right insulation tape 142 and the left insulation tape 144 are at least partially pasted to each other. Specifically, as illustrated in Fig. 4, the right insulation tape 142 and the left insulation tape 144 at least partially overlap directly each other in the Y direction without the exterior member 120 and the negative electrode terminal 134 interposed. In the example illustrated in Fig. 4, an upper end portion of the right insulation tape 142 and an upper end portion of the left insulation tape 144 are pasted to each other. A lower end portion of the right insulation tape 142 and a lower end portion of the left insulation tape 144 are also pasted to each other. Thus, the right insulation tape 142 and the left insulation tape 144 can be adhered to each other with strong force compared with when no portions of the first insulation tape 140 are pasted to each other. Accordingly, the right insulation tape 142 and the left insulation tape 144 can be fixed with strong force to the front end portion of the front sealing portion 122 compared with when no portions of the first insulation tape 140 are pasted to each other.

The right insulation tape 142 and the left insulation tape 144 have a peel adhesion strength of, for example, 0.050 N/mm or greater, preferably 0.075 N/mm or greater, or more preferably 0.10 N/mm or greater. The peel adhesion strength of the right insulation tape 142 and the left insulation tape 144 is measured based on a 180° peel test defined in JIS K6854-1:1999.

For example, in the right-side cell group 100G illustrated in Fig. 2, temperature at the front end portion of the front sealing portion 122 may become relatively high due to heat generated from the negative electrode terminal 134. In the embodiment 1, the right insulation tape 142 and the left insulation tape 144 are at least partially pasted to each other even if the temperature at the front end portion of the front sealing portion 122 becomes relatively high. Thus, peeling of the first insulation tape 140 due to heat generated from the negative electrode terminal 134 can be prevented compared with when no portions of the first insulation tape 140 are pasted to each other.

The first insulation tape 140 covers the front end face of the front sealing portion 122 around the negative electrode terminal 134. Thus, the metal layer such as an aluminum layer included in the laminate films composing the exterior member 120 can be prevented from being exposed from the front end face of the front sealing portion 122. If, in the example illustrated in Fig. 2, aluminum is exposed from the front end face of the front sealing portion 122 of the right battery cell 100 in the right cell group 100G as viewed from above, the aluminum may contact with copper on a surface of the negative electrode terminal 134 of the left battery cell 100 in the right cell group 100G as viewed from above. The contact between dissimilar metals of the aluminum on the front end face of the front sealing portion 122 and the copper on the surface of the negative electrode terminal 134 may cause corrosion on the aluminum on the front end face of the front sealing portion 122 due to a potential difference between the dissimilar metals. In the embodiment 1, on the other hand, the first insulation tape 140 can prevent the contact between the aluminum on the front end face of the front sealing portion 122 and the copper on the surface of the negative electrode terminal 134. Thus, the corrosion of the aluminum on the front end face of the front sealing portion 122 can be prevented compared with when the first insulation tape 140 is not provided.

Examples of the contact between dissimilar metals are not limited to the aluminum on the front end face of the front sealing portion 122 and the copper on the surface of the negative electrode terminal 134. Examples of the contact between dissimilar metals also include the contact between a metal on the front end face of the front sealing portion 122 of one battery cell 100 in the left cell group 100G illustrated in Fig. 2 and a metal on a surface of the positive electrode terminal 132 of the other battery cell 100. For example, in the example illustrated in Fig. 2, stainless steel may be exposed from the front end face of the front sealing portion 122 of the left battery cell 100 in the left cell group 100G as viewed from above, and the surface of the positive electrode terminal 132 of the right battery cell 100 in the left cell group 100G as viewed from above may be made of aluminum. In this example, the second insulation tape 150 can prevent the contact between the dissimilar metals of the stainless steel on the front end face of the front sealing portion 122 and the aluminum on the surface of the positive electrode terminal 132.

When no contact between dissimilar metals occurs, the first insulation tape 140 or the second insulation tape 150 may not be provided. For example, in the example illustrated in Fig. 2, aluminum may be exposed from the front end face of the front sealing portion 122 of the left battery cell 100 in the left cell group 100G as viewed from above, and the surface of the positive electrode terminal 132 of the right battery cell 100 in the left cell group 100G as viewed from above may be made of aluminum. In this example, no contact between dissimilar metals occurs even if the front end face of the front sealing portion 122 and the surface of the positive electrode terminal 132 contact. Thus, the second insulation tape 150 may not be provided in this example.

In the examples illustrated in Figs. 4 and 5, two insulation tapes of the right insulation tape 142 and the left insulation tape 144 are pasted to each other. However, three or more insulation tapes may be pasted to one another.

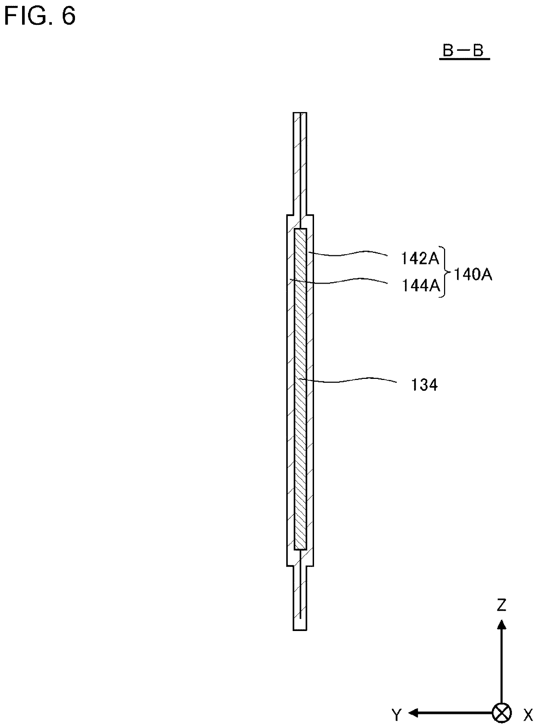

Fig. 6 is a sectional schematic view for describing a first insulation tape 140A of a battery cell according to a variant 1.1. The battery cell according to the variant 1.1 is similar to the battery cell 100 according to the embodiment 1 except for a following point. The cross section illustrated in Fig. 6 is located at a substantially identical position of the B-B cross section according to the embodiment 1.

A sheet of the first insulation tape 140A according to the variant 1.1 is folded at a lower end portion of the negative electrode terminal 134. Accordingly, the first insulation tape 140A includes a right folded portion 142A and a left folded portion 144A. The right folded portion 142A is located on the right side relative to the fold of the first insulation tape 140A at the lower end portion of the negative electrode terminal 134 as viewed from the front. The right folded portion 142A covers a right side face of the negative electrode terminal 134. The left folded portion 144A is located on the left side relative to the fold of the first insulation tape 140A at the lower end portion of the negative electrode terminal 134 as viewed from the front. The left folded portion 144A covers a left side face of the negative electrode terminal 134.

The right folded portion 142A and the left folded portion 144A are at least partially pasted to each other similarly to the right insulation tape 142 and the left insulation tape 144 according to the embodiment 1. Specifically, the right folded portion 142A and the left folded portion 144A at least partially overlap directly each other in the Y direction without the exterior member 120 and the negative electrode terminal 134 interposed similarly to the example illustrated in Fig. 4. Accordingly, portions of one sheet of the first insulation tape 140A are bonded to each other. Thus, the right folded portion 142A and the left folded portion 144A can be fixed with strong force to the front end face of the front sealing portion 122 compared with when no portions of the first insulation tape 140A are pasted to each other.

In the variant 1.1 as well, the first insulation tape 140A covers the front sealing portion 122 around the negative electrode terminal 134 similarly to the embodiment 1. Thus, the first insulation tape 140A can prevent the contact between dissimilar metals of a metal on the front end face of the front sealing portion 122 and a metal on the surface of the negative electrode terminal 134 similarly to the embodiment 1.

In the example illustrated in Fig. 6, the first insulation tape 140A is folded at the lower end portion of the negative electrode terminal 134. The first insulation tape 140A, however, may be folded at the upper end portion of the negative electrode terminal 134.

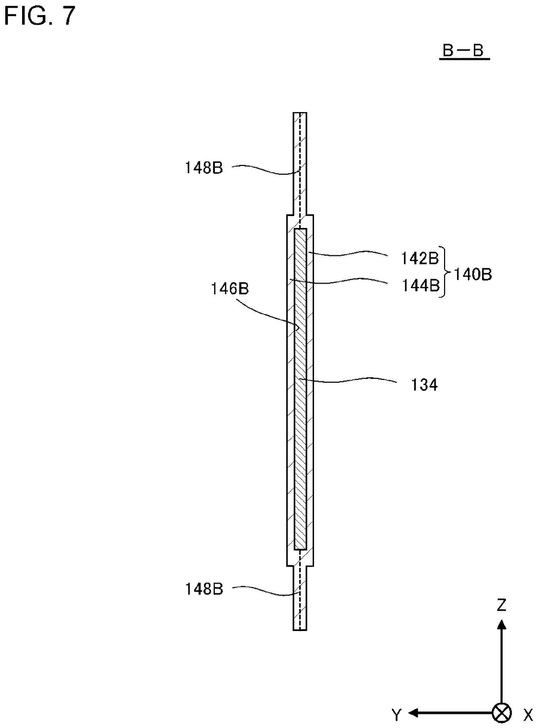

Fig. 7 is a sectional schematic view for describing a first insulation tape 140B of a battery cell according to a variant 1.2. The battery cell according to the variant 1.2 is similar to the battery cell 100 according to the embodiment 1 except for a following point. The cross section illustrated in Fig. 7 is located at a substantially identical position of the B-B cross section according to the embodiment 1.

The first insulation tape 140B according to the variant 1.2 defines a slit 146B. The negative electrode terminal 134 is drawn frontward out of the slit 146B. The first insulation tape 140B includes a right bent portion 142B and a left bent portion 144B. The right bent portion 142B is bent backward relative to the slit 146B. The left bent portion 144B is bent backward relative to the slit 146B. Fig. 7 schematically depicts a dashed line as a bending line 148B formed on the first insulation tape 140B by bending the right bent portion 142B and the left bent portion 144B.

The right bent portion 142B and the left bent portion 144B are at least partially pasted to each other similarly to the right insulation tape 142 and the left insulation tape 144 according to the embodiment 1. Specifically, the right bent portion 142B and the left bent portion 144B at least partially overlap directly each other in the Y direction without the exterior member 120 and the negative electrode terminal 134 interposed similarly to the example illustrated in Fig. 4. Thus, the right bent portion 142B and the left bent portion 144B can be fixed with strong force to the front end face of the front sealing portion 122 compared with when no portions of the first insulation tape 140B are pasted to each other.

In the variant 1.2 as well, the first insulation tape 140B covers front sealing portion 122 around the negative electrode terminal 134 similarly to the embodiment 1. Thus, the first insulation tape 140B can prevent the contact between the dissimilar metals of a metal on the front end face of the front sealing portion 122 and a metal on the surface of the negative electrode terminal 134 similarly to the embodiment 1.

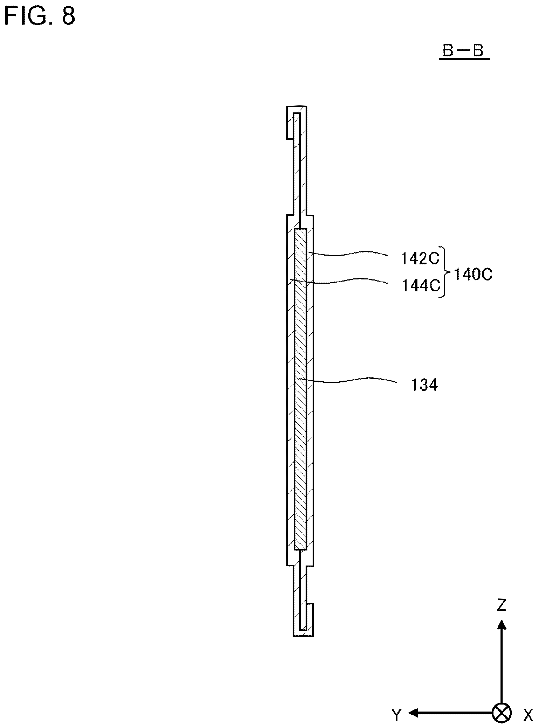

Fig. 8 is a sectional schematic view for describing a first insulation tape 140C of a battery cell according to a variant 1.3. The battery cell according to the variant 1.3 is similar to the battery cell 100 according to the embodiment 1 except for a following point. The cross section illustrated in Fig. 8 is located at a substantially identical position of the B-B cross section according to the embodiment 1.

The first insulation tape 140C according to the variant 1.3 includes a right insulation tape 142C and a left insulation tape 144C. The upper end portion of the right insulation tape 142C covers the upper end portion of the left insulation tape 144C. In the example illustrated in Fig. 8, the upper end portion of the right insulation tape 142C has a folded portion folded downward. The folded portion of the upper end portion of the right insulation tape 142C covers the upper end portion of the left insulation tape 144C. The lower end portion of the left insulation tape 144C covers the lower end portion of the right insulation tape 142C. In the example illustrated in Fig. 8, the lower end portion of the left insulation tape 144C has a folded portion folded upward. The folded portion of the lower end portion of the left insulation tape 144C covers the lower end portion of the right insulation tape 142C.

In the variant 1.3, a pasting interface between the upper end portion of the right insulation tape 142C and the upper end portion of the left insulation tape 144C is not exposed upward. Thus, the right insulation tape 142C and the left insulation tape 144C can be fixed with strong force to the front end face of the front sealing portion 122 compared with when the pasting interface is exposed upward. Similarly, a pasting interface between the lower end portion of the right insulation tape 142C and the lower end portion of the left insulation tape 144C is not exposed downward. Thus, the right insulation tape 142C and the left insulation tape 144C can be fixed with strong force to the front end face of the front sealing portion 122 compared with when the pasting interface is exposed downward.

In the variant 1.3 as well, the first insulation tape 140C covers the front sealing portion 122 around the negative electrode terminal 134 similarly to the embodiment 1. Thus, the first insulation tape 140C can prevent the contact between the dissimilar metals of a metal on the front end face of the front sealing portion 122 and a metal on the surface of the negative electrode terminal 134 similarly to the embodiment 1.

The pasting between the right insulation tape 142C and the left insulation tape 144C is not limited to the variant 1.3. For example, the upper end portion of the left insulation tape 144C may cover the upper end portion of the right insulation tape 142C. The lower end portion of the right insulation tape 142C may cover the lower end portion of the left insulation tape 144C.

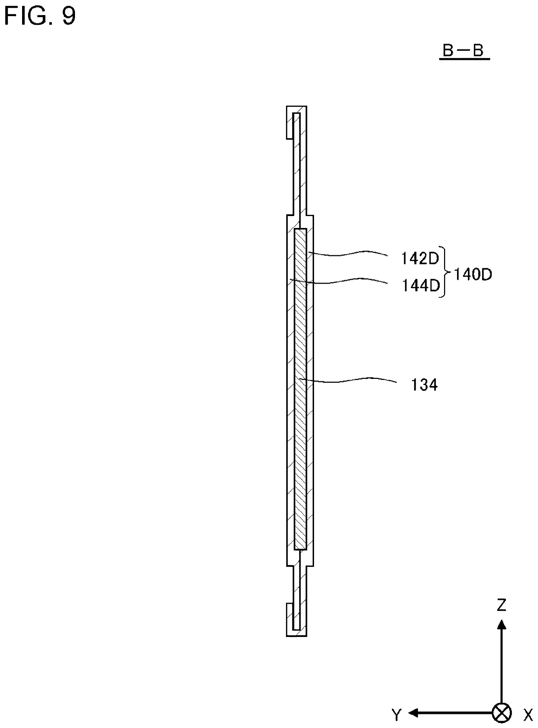

Fig. 9 is a sectional schematic view for describing a first insulation tape 140D of a battery cell according to a variant 1.4. The battery cell according to the variant 1.4 is similar to the battery cell 100 according to the embodiment 1 except for a following point. The cross section illustrated in Fig. 9 is located at a substantially identical position of the B-B cross section according to the embodiment 1.

The first insulation tape 140D according to the variant 1.4 includes a right insulation tape 142D and a left insulation tape 144D. The upper end portion of the right insulation tape 142D covers the upper end portion of the left insulation tape 144D. In the example illustrated in Fig. 9, the upper end portion of the right insulation tape 142D has a folded portion folded downward. The folded portion of the upper end portion of the right insulation tape 142D covers the upper end portion of the left insulation tape 144D. The lower end portion of the right insulation tape 142D covers the lower end portion of the left insulation tape 144D. In the example illustrated in Fig. 9, the lower end portion of the right insulation tape 142D has a folded portion folded upward. The folded portion of the lower end portion of the right insulation tape 142D covers the lower end portion of the left insulation tape 144D.

In the variant 1.4, a pasting interface between the upper end portion of the right insulation tape 142D and the upper end portion of the left insulation tape 144D is not exposed upward. Thus, the right insulation tape 142D and the left insulation tape 144D can be fixed with strong force to the front end face of the front sealing portion 122 compared with when the pasting interface is exposed upward. Similarly, a pasting interface between the lower end portion of the right insulation tape 142D and the lower end portion of the left insulation tape 144D is not exposed downward. Thus, the right insulation tape 142D and the left insulation tape 144D can be fixed with strong force to the front end face of the front sealing portion 122 compared with when the pasting interface is exposed downward.

In the variant 1.4 as well, the first insulation tape 140D covers the front sealing portion 122 around the negative electrode terminal 134 similarly to the embodiment 1. Thus, the first insulation tape 140D can prevent the contact between the dissimilar metals of a metal on the front end face of the front sealing portion 122 and a metal on the surface of the negative electrode terminal 134 similarly to the embodiment 1.

The pasting between the right insulation tape 142D and the left insulation tape 144D is not limited to the variant 1.4. For example, the upper end portion and the lower end portion of the left insulation tape 144D may cover the upper end portion and the lower end portion of the right insulation tape 142D respectively. Alternatively, only at one of the upper end portion and the lower end portion of the right insulation tape 142D and the left insulation tape 144D, the upper end portion or the lower end portion of one of the right insulation tape 142D and the left insulation tape 144D may cover the upper end portion or the lower end portion of the other of the right insulation tape 142D and the left insulation tape 144D.

While the embodiment 1 and the variants of the present invention have been described with reference to the drawings, the embodiment 1 and the variants are illustrative of the present invention, and various configurations other than the above can be employed.

In the embodiment 1 and the variants, the insulation tape is at least partially pasted to each other. In other words, the insulation tape is at least partially bonded to each other. Examples of the insulation material covering the exterior member 120 around the positive electrode terminal 132 or the negative electrode terminal 134, however, include not only the insulation tape but also a coating agent formed by coating or a heat-shrink film. In use of the insulation material, the insulation material can be at least partially bonded to each other. In this case, the insulation material can be fixed with strong force to the exterior member 120 around the positive electrode terminal 132 or the negative electrode terminal 134 compared with when no portions of the insulation material are pasted to each other as described in the embodiment 1 and the variants.

### (Embodiment 2)

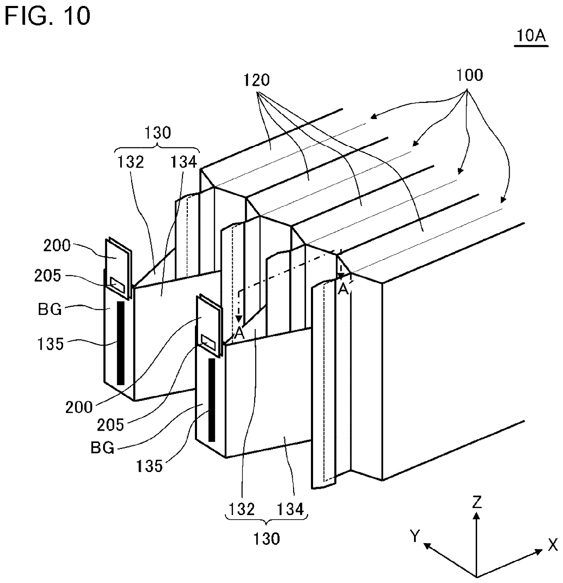

Hereinafter, an embodiment 2 and variants of the present invention will be described by using the drawings. A similar component is assigned with a similar reference sign throughout all the drawings in Figs. 10 to 21 relating to the embodiment 2, and description therefor will be omitted as appropriate.

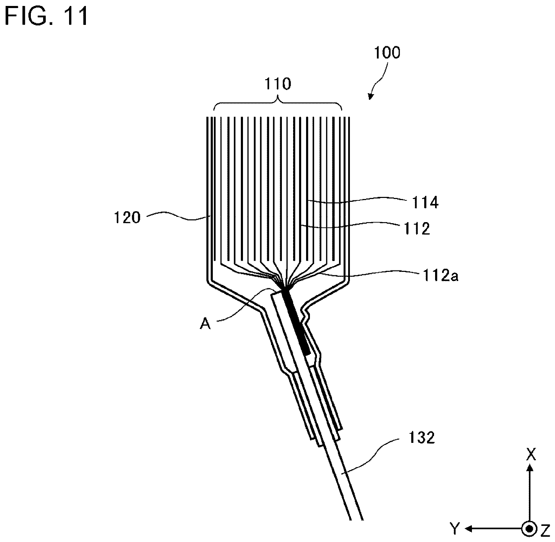

Fig. 10 is a perspective view of a front portion of a battery module 10A according to an embodiment 2. Fig. 11 is an A-A' sectional view of Fig. 10.

For illustrative purposes, arrows indicating X direction, Y direction, and Z directions are assigned in each figure. The X direction indicates a front-rear direction of the battery module 10A. Hereinafter, a tip end side of the arrow indicating the X direction is a rear side of the battery module 10A unless otherwise specified. Hereinafter, a base end side of the arrow indicating the X direction is a front side of the battery module 10A unless otherwise specified. The Y direction is perpendicular to the X direction. The Y direction indicates a left-right direction of the battery module 10A. Hereinafter, a tip end side of the arrow indicating the Y direction is a left side of the battery module 10A unless otherwise specified. Hereinafter, a base end side of the arrow indicating the Y direction is a right side of the battery module 10A unless otherwise specified. The Z direction is perpendicular to both of the X direction and Y direction. The Z direction indicates an up-down direction of the battery module 10A. Hereinafter, a tip end side of the arrow indicating the Z direction is an upper side of the battery module 10A unless otherwise specified. Hereinafter, a base end side of the arrow indicating the Z direction is a lower side of the battery module 10A unless otherwise specified. In Fig. 11, a circle with a dot indicating the Z direction indicates the upper side of the battery module 10 from the back toward the front of the plane of the paper and the lower side of the battery module 10A from the front toward the back of the plane of the paper. The relationship between the X direction, Y direction, and Z direction and the front-rear, left-right, and up-down directions of the battery module 10A, however, is not limited to the above example. The relationship therebetween differs depending on actual arrangement of the battery module 10A.

The battery module 10A will be described with reference to Fig. 10 and with reference to Fig. 11 as needed.

The battery module 10A includes a plurality of battery cells 100 and a plurality of voltage detection portions 200.

The example illustrated in Fig. 10 illustratively illustrates four battery cells 100. The number of the battery cells 100 included in the battery module 10A, however, is not limited to the example illustrated in Fig. 10. The plurality of battery cells 100 is stacked in the Y direction. In the example illustrated in Fig. 10, each of the battery cells 100 has a long direction substantially parallel to the X direction. Each of the battery cells 100 has a short direction substantially parallel to the Z direction. Each of the battery cells 100 has a thickness direction substantially parallel to the Y direction. The shape of each of the battery cells 100, however, is not limited to the example illustrated in Fig. 10.

As illustrated in Figs. 10 and 11, each of the battery cells 100 includes a battery element 110, an exterior member 120, a positive electrode tab 132, and a negative electrode tab 134.

As illustrated in Fig. 11, the battery element 110 includes a plurality of positive electrodes 112 and a plurality of negative electrodes 114. The plurality of positive electrodes 112 and the plurality of negative electrodes 114 are alternatingly stacked in the Y direction. The positive electrode 112 and the negative electrode 114 adjacent in the Y direction are separated from each other by a not-illustrated separator. The structure of the battery element 110, however, is not limited to this example.

As illustrated in Fig. 11, the exterior member 120 seals the battery element 110 and a not-illustrated electrolyte.

The positive electrode tab 132 is electrically connected to the plurality of positive electrodes 112. The electrical connection between the positive electrode tab 132 and the plurality of positive electrodes 112 will be described with reference to the example illustrated in Fig. 11. In the example illustrated in Fig. 11, the positive electrode tab 132 is located in front of the battery element 110. The base end A on a rear end side of the positive electrode tab 132 is located within an area sealed by the exterior member 120. In the example illustrated in Fig. 11, the positive electrode tab 132 obliquely extends from the base end A toward right front as viewed from above. The positive electrode tab 132 is bonded to a plurality of positive electrode current collector foils 112a. In the example illustrated in Fig. 11, the plurality of positive electrode current collector foils 112a is drawn out of the plurality of positive electrodes 112 frontward of the battery element 110 and is integrally bundled at a portion near the base end A of the positive electrode tab 132. Thereby, the positive electrode tab 132 is electrically connected to the plurality of positive electrodes 112. Similarly to the example illustrated in Fig. 11, the negative electrode tab 134 is electrically connected to the plurality of negative electrodes 114 via a plurality of not-illustrated negative electrode current collector foils drawn out of the plurality of negative electrodes 114.

In each of the battery cells 100, the positive electrode tab 132 and the negative electrode tab 134 are drawn out of opposite sides of the exterior member 120 in the X direction. The positive electrode tab 132 is made of, for example, aluminum. The negative electrode tab 134 is made of, for example, copper. In the battery cells 100 adjacent in the Y direction, the positive electrode tab 132 and the negative electrode tab 134 of each of the battery cells 100 alternate in the X direction. In the example illustrated in Fig. 10, for example, accordingly, the leftmost battery cell 100 includes the positive electrode tab 132 located in front of the battery cell 100 and includes a not-illustrated negative electrode tab 134 located behind the battery cell 100. In the example illustrated in Fig. 10, the second leftmost battery cell 100 includes the negative electrode tab 134 located in front of the battery cell 100 and includes a not-illustrated positive electrode tab 132 located behind the battery cell 100.

The battery cells 100 adjacent in the Y direction include a tab group 130 located in front of or behind the adjacent battery cells 100. Each tab group 130 includes the positive electrode tab 132 and the negative electrode tab 134 bonded to each other. Each tab group 130 includes a tip end portion group BG. The tip end portion group BG includes a tip end portion of the positive electrode tab 132 and a tip end portion of the negative electrode tab 134. In the example illustrated in Fig. 10, a plurality of tip end portion groups BG located in front of the battery module 10A are all bent toward the identical direction as viewed from above. Thereby, the tip end portion group BG is substantially parallel to the Y direction. Accordingly, the voltage detection portion 200 can be easily bonded to a front face of the tip end portion group BG while the voltage detection portion 200 has a thickness direction substantially parallel to the X direction. The tip end portion group BG is provided with a first bonding portion 135. The positive electrode tab 132 and the negative electrode tab 134 included in each tab group 130 are bonded to each other at the first bonding portion 135. The first bonding portion 135 is formed by, for example, laser welding. The method of forming the first bonding portion 135, however, is not limited to this example.

A plurality of tab groups 130 located in front of the plurality of battery cells 100 and a plurality of not-illustrated tab groups 130 located behind the plurality of battery cells 100 are arranged alternately in the Y direction. Thereby, the battery cells 100 adjacent in the Y direction are connected in series. In the example illustrated in Fig. 10, for example, the left two battery cells 100 are connected in series via the tab group 130 located in front of the battery cells 100. In the example illustrated in Fig. 10, the central two battery cells 100 are connected in series via a not-illustrated tab group 130 located behind the battery cells 100.

Each of the plurality of voltage detection portions 200 is bonded to each of the plurality of tip end portion groups BG. Each voltage detection portion 200 is made of, for example, a conductor such as a metal. In the example illustrated in Fig. 10, the voltage detection portion 200 is bonded to the front face of the tip end portion group BG located in front of the battery module 10A. Each voltage detection portion 200 and each tip end portion group BG are bonded to each other at a second bonding portion 205. The second bonding portion 205 is formed by, for example, laser welding. The method of forming the second bonding portion 205, however, is not limited to this example.

Each of a plurality of not-illustrated voltage detection lines is electrically connected to each of the plurality of voltage detection portions 200. Accordingly, the voltage of each tab group 130 can be detected by each voltage detection portion 200 and each voltage detection line.

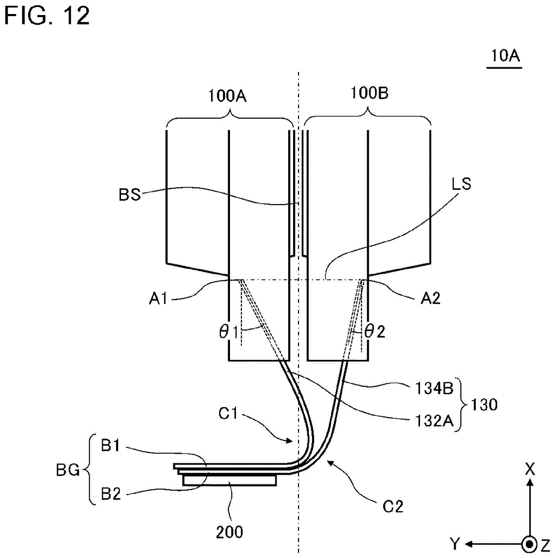

Fig. 12 is a top view of a front portion of a first battery cell 100A and a second battery cell 100B among the plurality of battery cells 100 according to the embodiment 2.

The first battery cell 100A and the second battery cell 100B are adjacent in the Y direction. The first battery cell 100A is located on the left side of the second battery cell 100B as viewed from above. The second battery cell 100B is located on the right side of the first battery cell 100A as viewed from above.

The first battery cell 100A includes a first positive electrode tab 132A. The first positive electrode tab 132A includes a first base end A1, a first tip end portion B1, and a first bent portion C1. The second battery cell 100B includes a second negative electrode tab 134B. The second negative electrode tab 134B includes a second base end A2, a second tip end portion B2, and a second bent portion C2. The first positive electrode tab 132A and the second negative electrode tab 134B compose the tab group 130. The first tip end portion B1 and the second tip end portion B2 compose the tip end portion group BG.

Fig. 12 illustrates a virtual line segment LS and a virtual bisector BS. The virtual line segment LS connects the first base end A1 and the second base end A2 as viewed from above. The virtual line segment LS is substantially parallel to the Y direction as viewed from above. The virtual bisector BS is a perpendicular bisector of the virtual line segment LS as viewed from above. The virtual bisector BS is substantially parallel to the X direction as viewed from above.

The first tip end portion B1 is bent toward the left direction about the first bent portion C1 as viewed from above. The second tip end portion B2 is bent toward the left direction about the second bent portion C2 as viewed from above. The first bent portion C1 and the second bent portion C2 are offset rightward relative to the virtual bisector BS as viewed from above. In other words, the first bent portion C1 and the second bent portion C2 are offset relative to the virtual bisector BS toward the opposite side of the direction toward which the first tip end portion B1 and the second tip end portion B2 are bent.

A portion of the first positive electrode tab 132A between the first base end A1 and the first bent portion C1 is tilted by a first angle θ1 relative to the X direction as viewed from above. A portion of the second negative electrode tab 134B between the second tip end portion B2 and the second bent portion C2 is tilted by a second angle θ2 relative to the X direction as viewed from above. As described above, the first bent portion C1 and the second bent portion C2 are offset rightward relative to the virtual bisector BS as viewed from above. Thereby, the second angle θ2 is less than the first angle θ1.

In the embodiment 2, the fluctuation in locations of the first base end A1 and the second base end A2 or fluctuation in the first angle θ1 and the second angle θ2 caused by bending the first positive electrode tab 132A and the second negative electrode tab 134B can be suppressed. Thus, a phenomenon such as disconnection of the current collector foil caused by the fluctuation in locations of the first base end A1 and the second base end A2 or the fluctuation in the first angle θ1 and the second angle θ2 can be prevented. Specifically, the first bent portion C1 of the first positive electrode tab 132A has a radius of curvature less than a radius of curvature of the second bent portion C2 of the second negative electrode tab 134B as viewed from above. In the embodiment 2, as viewed from above, the offset of the first bent portion C1 toward the side of the second bent portion C2 can match the length of the first positive electrode tab 132A at or near the first bent portion C1 and the length of the second negative electrode tab 134B at or near the second bent portion C2. In the embodiment 2, therefore, it can be unlikely that the first base end A1 would move backward due to an excess length of the first positive electrode tab 132A at or near the first bent portion C1 as viewed from above. In the embodiment 2, it can be unlikely that the second base end A2 would move frontward due to an insufficient length of the second negative electrode tab 134B at or near the second bent portion C2 as viewed from above.

In the example illustrated in Fig. 12, the tip end portion group BG is bent toward the left direction as viewed from above. The tip end portion group BG, however, may be bent toward the right direction as viewed from above. In this case, the first bent portion C1 and the second bent portion C2 can be offset leftward relative to the virtual bisector BS.

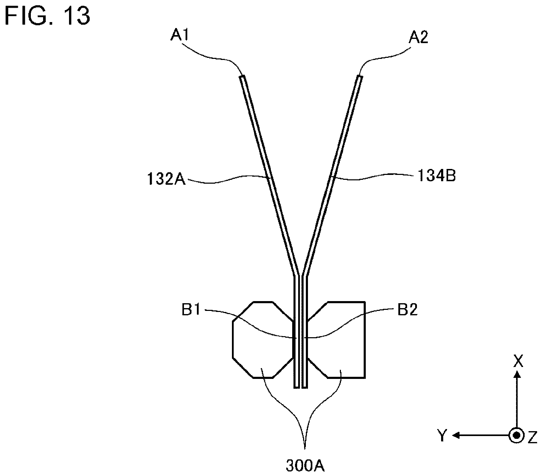

Figs. 13 to 15 are views for describing a first example of a method of manufacturing the battery module 10A according to the embodiment 2. In the first example, the battery module 10A according to the embodiment 2 is manufactured as follows.

First, the first battery cell 100A and the second battery cell 100B are arranged adjacent to each other in the Y direction with the first positive electrode tab 132A and the second negative electrode tab 134B drawn out frontward.

Next, the first tip end portion B1 and the second tip end portion B2 are bonded to each other to form the first bonding portion 135. The first tip end portion B1 and the second tip end portion B2 are bonded by, for example, laser welding. The method of bonding the first tip end portion B1 and the second tip end portion B2, however, is not limited to this example. In laser welding in the embodiment 2, laser can be applied from both the left and right sides of the first tip end portion B1 and the second tip end portion B2. For this reason, workability of bonding the first tip end portion B1 and the second tip end portion B2 can be improved.

The order of processes for bonding the first tip end portion B1 and the second negative electrode tab 134B is not limited to the above example. For example, the first tip end portion B1 and the second tip end portion B2 may be bonded after the first tip end portion B1 and the second tip end portion B2 are bent as described later.

Next, as illustrated in Fig. 13, the first tip end portion B1 and the second tip end portion B2 are pinched by a pair of bending fingers 300A.

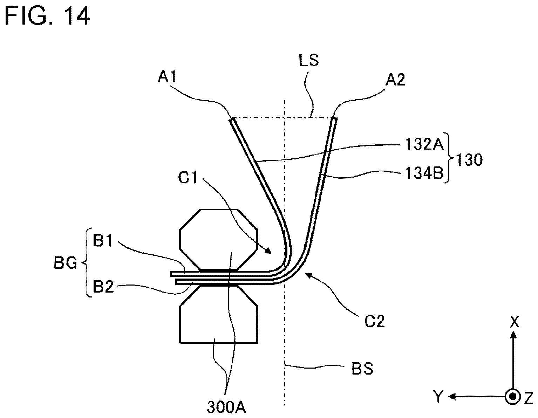

Next, as illustrated in Fig. 14, the pair of bending fingers 300A are rotated clockwise as viewed from above. Thereby, the first tip end portion B1 and the second tip end portion B2 are bent toward the left direction as viewed from above. In the example illustrated in Fig. 14, the first positive electrode tab 132A and the second negative electrode tab 134B are bent such that the first bent portion C1 and the second bent portion C2 are offset rightward relative to the virtual bisector BS as viewed from above. This can prevent the fluctuation in locations of the first base end A1 and the second base end A2 caused by bending the first positive electrode tab 132A and the second negative electrode tab 134B as described above.

Next, the pair of bending fingers 300A are detached from the tab group 130. In this case, the bending finger 300A located behind the tip end portion group BG can be moved frontward of the tab group 130 through a space on the left side of the tip end portion group BG as viewed from above. In the embodiment 2, the plurality of tip end portion groups BG located in front of the battery module 10A are bent toward the identical direction. In the example illustrated in Fig. 10, for example, the tip end portion groups BG of the tab groups 130 adjacent in the Y direction are both bent toward the left direction as viewed from above. In this example, the space between the tip end portion groups BG adjacent in the Y direction can have a wide width in the Y direction compared with when the left tip end portion group BG illustrated in Fig. 10 is bent toward the right direction as viewed from above and the right tip end portion group BG illustrated in Fig. 10 is bent toward the left direction as viewed from above. Thus, in the embodiment 2, the bending finger 300A located behind the right tip end portion group BG illustrated in Fig. 10 can be easily taken out frontward of the tab group 130 through the space between the tip end portion groups BG adjacent in the Y direction. Accordingly, in the embodiment 2, workability for detaching the pair of bending fingers 300A from the tab group 130 can be improved.

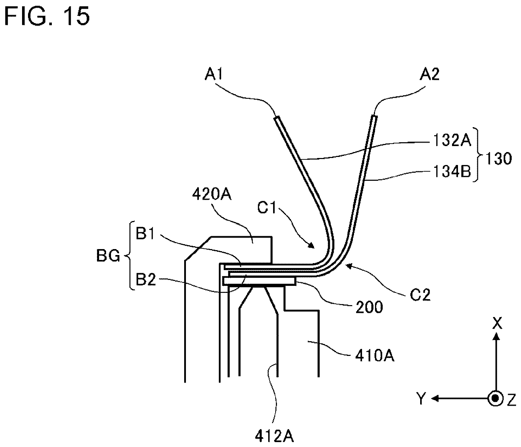

Next, as illustrated in Fig. 15, the tip end portion group BG and the voltage detection portion 200 are pinched by a first laser finger 410A and a second laser finger 420A with the voltage detection portion 200 arranged in front of the tip end portion group BG. The first laser finger 410A is arranged in front of the voltage detection portion 200. The second laser finger 420A is arranged behind the tip end portion group BG. Next, laser is irradiated toward a front face of the voltage detection portion 200 through a laser hole 412A provided in the first laser finger 410A. Thereby, the second bonding portion 205 is formed to bong the voltage detection portion 200 to the tip end portion group BG.

In the example illustrated in Fig. 15, there is a space on the left side of the tip end portion group BG to enter the second laser finger 420A rearward of the tip end portion group BG as viewed from above. Thus, the second laser finger 420A can be arranged behind the tip end portion group BG without moving the second laser finger 420A upward or downward. Thus, workability for arranging the second laser finger 420A behind the tip end portion group BG can be improved.

The order of processes for bonding the voltage detection portion 200 to the tip end portion group BG is not limited to the above example. For example, the voltage detection portion 200 may be bonded to the tip end portion group BG before the tip end portion group BG is bent.

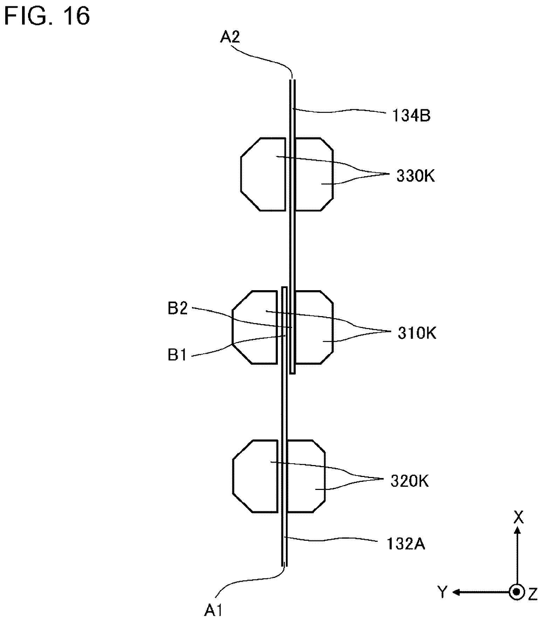

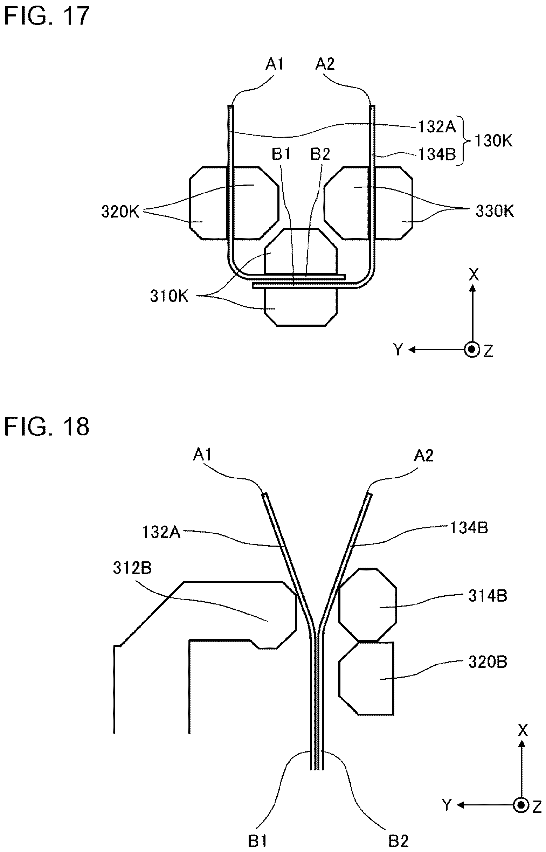

Figs. 16 and 17 are views for describing a method of manufacturing a battery module according to a comparative embodiment. The method of manufacturing the battery module according to the comparative embodiment is similar to the method of manufacturing the battery module 10A according to the embodiment 2 except for a following point.

First, the first battery cell 100A and the second battery cell 100B are arranged in the X direction with the first tip end portion B1 and the second tip end portion B2 overlapping in the Y direction.

Next, as illustrated in Fig. 16, the first tip end portion B1 and the second tip end portion B2 are pinched by a pair of first bending fingers 310K. A portion of the first positive electrode tab 132A between the first base end A1 and the first tip end portion B1 is pinched by a pair of second bending fingers 320K. A portion of the second negative electrode tab 134B between the second base end A2 and the second tip end portion B2 is pinched by a pair of third bending fingers 330K.

Next, the pair of first bending fingers 310K and the pair of third bending fingers 330K are rotated clockwise as viewed from above with locations of the pair of third bending fingers 330K fixed. Thereby, a portion of the second negative electrode tab 134B between the pair of first bending fingers 310K and the pair of third bending fingers 330K is bent at a substantially right angle as viewed from above.

Next, as illustrated in Fig. 17, the pair of second bending fingers 320K are rotated clockwise as viewed from above with locations of the pair of first bending fingers 310K and the pair of third bending fingers 330K fixed. Thereby, a portion of the first positive electrode tab 132A between the pair of first bending fingers 310K and the pair of second bending fingers 320K is bent at a substantially right angle as viewed from above. Thereby, the first positive electrode tab 132A and the second negative electrode tab 134B form a fold tab group 130K. The fold tab group 130K is folded between the first base end A1 and the second base end A2.

Next, the voltage detection portion 200 is bonded to a front face of the first tip end portion B1.

The embodiment 2 illustrated in Figs. 13 to 15 is compared with the comparative embodiment illustrated in Figs. 16 and 17.

In the comparative embodiment, the shorter distance in the Y direction of the folded tab group 130K between the first base end A1 and the second base end A2 requires a thinner width in a direction perpendicular to the Z direction of the first bending finger 310K, the second bending finger 320K, and the third bending finger 330K located inside the folded tab group 130K. The narrower width of each finger is likely to cause a larger deflection of each finger relative to the Z direction. Accordingly, in the comparative embodiment, the shorter distance in the Y direction of the folded tab group 130K between the first base end A1 and the second base end A2 may make it more difficult to form the folded tab group 130K. In the embodiment 2, on the other hand, the first tip end portion B1 and the second tip end portion B2 can be bent regardless of the distance in the Y direction between the first base end A1 and the second base end A2. Thus, in the embodiment 2, workability for bending the tip end portion group BG can be improved compared with the comparative embodiment.

In the comparative embodiment, the fingers need to be moved upward or downward to detach the first bending finger 310K, the second bending finger 320K, and the third bending finger 330K located inside the folded tab group 130K. In the embodiment 2, on the other hand, the bending finger 300A located behind the tip end portion group BG can be taken out through the space between the tip end portion groups BG adjacent in the Y direction. Thus, in the embodiment 2, the bending finger 300A located behind the tip end portion group BG can be detached without moving the bending finger 300A upward or downward. Thus, in the embodiment 2, workability for detaching the bending finger 300A located behind the tip end portion group BG can be improved compared with the comparative embodiment.

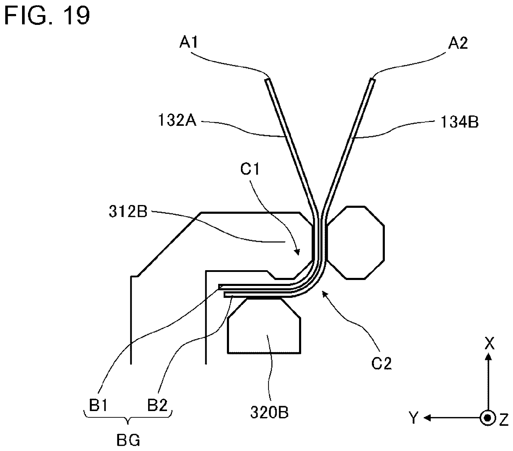

Figs. 18 and 19 are views for describing a second example of the method of manufacturing the battery module 10A according to the embodiment 2. The second example illustrated in Figs. 18 and 19 is similar to the first example illustrated in Figs. 13 to 15 except for a following point.

As illustrated in Fig. 18, a portion of the first positive electrode tab 132A between the first tip end portion B1 and the first base end A1 and a portion of the second negative electrode tab 134B between the second tip end portion B2 and the second base end A2 are pinched by a first fixed bending finger 312B and a second fixed bending finger 314B. The first fixed bending finger 312B is arranged on the left side of the first positive electrode tab 132A as viewed from above. The second fixed bending finger 314B is arranged on the right side of the second negative electrode tab 134B as viewed from above. Next, a movable bending finger 320B is arranged in front of the second fixed bending finger 314B and on the right side of the second tip end portion B2 as viewed from above.

Next, as illustrated in Fig. 19, the movable bending finger 320B is rotated clockwise as viewed from above. Thereby, the tip end portion group BG is bent toward the left direction as viewed from above.

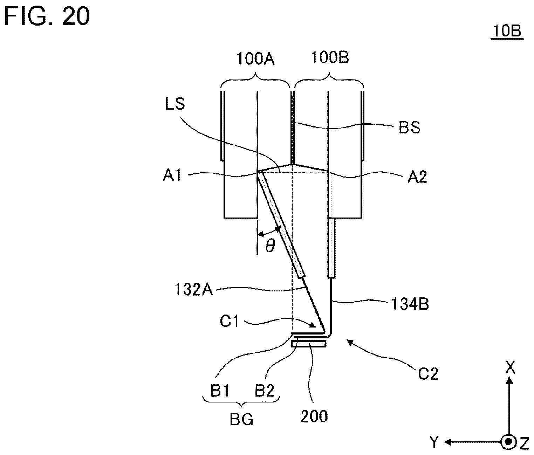

Fig. 20 is a top view of a front portion of a battery module 10B according to a variant 2.1. The battery module 10B according to the variant 2.1 is similar to the battery module 10A according to the embodiment 2 except for a following point.

In the variant 2.1, the tip end portion group BG is bent toward the left direction as viewed from above. The first bent portion C1 and the second bent portion C2 are offset rightward relative to the virtual bisector BS. A portion of the first positive electrode tab 132A between the first base end A1 and the first bent portion C1 is tilted by an angle θ relative to the X direction. A portion of the second negative electrode tab 134B between the second base end A2 and the second bent portion C2, on the other hand, is substantially parallel to the X direction. In the variant 2.1 as well, the fluctuation in locations of the first base end A1 and the second base end A2 caused by bending the first positive electrode tab 132A and the second negative electrode tab 134B can be prevented.

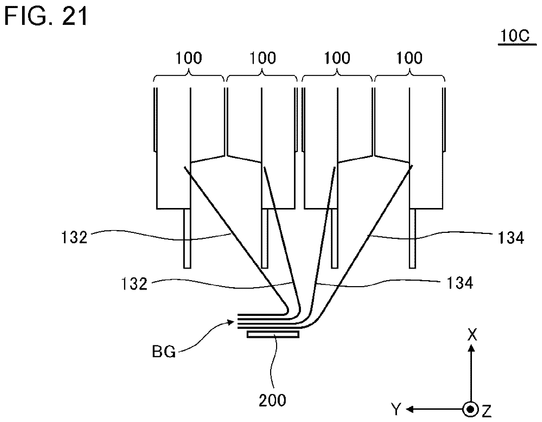

Fig. 21 is a top view of a front portion of a battery module 10C according to a variant 2.2. The battery module 10C according to the variant 2.2 is similar to the battery module 10A according to the embodiment 2 except for a following point.

The battery module 10C according to the variant 2.2 includes four battery cells 100 illustrated in Fig. 21. In the example illustrated in Fig. 21, the left two battery cells 100 are connected in parallel. In the example illustrated in Fig. 21, the right two battery cells 100 are connected in parallel. The left two battery cells 100 connected in parallel illustrated in Fig. 21 and the right two battery cells 100 connected in parallel illustrated in Fig. 21 are connected in series.

The two positive electrode tabs 132 are drawn frontward out of the left two battery cells 100 connected in parallel illustrated in Fig. 21. The two negative electrode tabs 134 are drawn frontward out of the right two battery cells 100 connected in parallel illustrated in Fig. 21. The tabs are bonded to one another. Specifically, the tip end portion group BG including tip end portions of the tabs is bent toward the left direction as viewed from above. In the tip end portion group BG, the tip ends of the tabs described above are bonded to one another. In the example illustrated in Fig. 21, the voltage detection portion 200 is bonded to a front face of the tip end portion group BG. In the variant 2.2 as well, workability for connecting in series the left two battery cells 100 connected in parallel illustrated in Fig. 21 and the right two battery cells 100 connected in parallel illustrated in Fig. 21 can be improved similarly to the embodiment 2.

In the example illustrated in Fig. 21, battery cell groups including two battery cells 100 connected in parallel are connected in series. a The structure similar to the structure described by using Fig. 21 can be employed, however, even if battery cell groups including three or more battery cells 100 connected in parallel are connected in series.

While the embodiment 2 and the variants of the present invention have been described with reference to the drawings, the embodiment 2 and the variants are illustrative of the present invention, and various configurations other than the above can be employed.

The battery cell 100 according to the embodiment 2 may include an insulation material such as an insulation tape covering the exterior member 120 around the positive electrode tab 132 or the negative electrode tab 134 similarly to the battery cell 100 according to the embodiment 1. In the battery cell 100 according to the embodiment 2 as well, the insulation material may be at least partially bonded to each other similarly to the battery cell 100 according to the embodiment 1. In the embodiment 2 as well, the insulation material can be fixed with strong force to the exterior member 120 around the positive electrode terminal 132 or the negative electrode terminal 134 when the insulation material is at least partially bonded to each other compared with when no portions of the insulation material are pasted to each other.

This application claims priorities based on Japanese patent application No. 2022-074724, filed on April 28, 2022 and Japanese patent application No. 2022-171314, filed on October 26, 2022, the disclosure of which is incorporated herein in its entirety by reference.

### REFERENCE SIGNS LIST

10, 10A, 10B, 10C Battery module, 100 Battery cell, 100A First battery cell, 100B Second battery cell, 100G Cell group, 110 Battery element, 112 Positive electrode, 112a Positive electrode current collector foil, 114 Negative electrode, 116 Separator, 120 Exterior member, 121 Accommodation portion, 122 Front sealing portion, 123 Rear sealing portion, 124 Upper sealing portion, 125 Lower sealing portion, 130 Terminal group, tab group, 130K Folded tab group, 132 Positive electrode terminal, positive electrode tab, 132A First positive electrode tab, 134 Negative electrode terminal, negative electrode tab, 134B Second negative electrode tab, 135 First bonding portion, 140, 140A, 140B, 140C, 140D First insulation tape, 142, 142C, 142D Right insulation tape, 142A Right folded portion, 142B Right bent portion, 144, 144C, 144D Left insulation tape, 144A Left folded portion, 144B Left bent portion, 146B Slit, 148B Bending line, 150 Second insulation tape 200 Voltage detection portion, 250 Second bonding portion, 300A Bending finger, 310K First bending finger, 312B First fixed bending finger, 314B Second fixed bending finger, 320B Movable bending finger, 320K Second bending finger, 330K Third bending finger, 410A First laser finger, 412A Laser hole, 420A Second laser finger, A Base end, A1 First base end, A2 Second base end, B1 First tip end portion, B2 Second tip end portion, BG Tip end portion group, BS Virtual bisector, C1 First bent portion, C2 Second bent portion, LS Virtual line segment

## Claims

1. A battery cell comprising:
a battery element;
an exterior member sealing the battery element;
a terminal electrically connected to the battery element and drawn out of the exterior member; and
an insulation material covering the exterior member around the terminal, wherein
the insulation material is at least partially bonded to each other.

2. The battery cell according to claim 1, wherein
the insulation material includes at least two insulation materials bonded to each other.

3. The battery cell according to claim 2, wherein
at least one of the at least two insulation materials covers an end portion of at least another one of the at least two insulation materials.

4. The battery cell according to claim 1, wherein
a sheet of the insulation material is folded and portions of the sheet of the insulation material are bonded to each other.

5. The battery cell according to claim 1, wherein
the insulation material defines a slit through which the terminal is drawn out.

6. A battery module comprising:
the battery cell according to any one of claims 1 to 5; and
another battery cell including another terminal being electrically connected to the terminal of the battery cell.

7. A battery module comprising:
at least one positive electrode tab including a predetermined first tip end portion bent about a predetermined first bent portion toward a predetermined direction; and
at least one negative electrode tab bonded to the at least one positive electrode tab, the at least one negative electrode tab including a predetermined second tip end portion bent about a predetermined second bent portion toward the predetermined direction, wherein
the first bent portion and the second bent portion are offset toward an opposite side of the predetermined direction relative to a virtual bisector of a virtual line segment connecting a predetermined first base end of the at least one positive electrode tab and a predetermined second base end of the at least one negative electrode tab.

8. The battery module according to claim 7, further comprising
a voltage detection portion bonded to at least one of the first tip end portion and the second tip end portion.

9. A battery module comprising
a plurality of tab groups including at least one positive electrode tab and at least one negative electrode tab bonded to each other, wherein
each of tip end portions of the plurality of tab groups is bent toward an identical direction.

10. The battery module according to claim 9, further comprising
a plurality of voltage detection portions bonded to the tip end portions of the plurality of tab groups.

11. A battery module comprising:
at least one positive electrode tab including a predetermined first tip end portion bent toward a predetermined direction;
at least one negative electrode tab bonded to the at least one positive electrode tab, the at least one negative electrode tab including a predetermined second tip end portion bent toward the predetermined direction; and
a voltage detection portion bonded to at least one of the first tip end portion and the second tip end portion.
